# EUROPEAN PATENT APPLICATION

(11) **EP 1 927 462 A1**
(43) Date of publication of application: **04.06.2008**
(21) Application number: 07254595.7
(22) Date of filing: 27.11.2007
(51) Int. Cl.: B29C 59/02, G03F 7/00

(54) **Apparatus for applying a controlled force to an article**

(30) Priority: 30.11.2006 GB 0623960
(71) Applicant: Cinetic Landis Grinding Limited, Cross Hills Keighley Yorkshire BD20 7SD (GB)
(72) Inventor: Joyce, Trevor Marcus, Buckinghamshire, MK 18 1AW (GB)
(74) Representative: Roberts, David Leslie

(57) **Abstract**

Apparatus, such a embossing apparatus, for applying a controlled amount of force to an article comprises a head (26) for engaging such an article to apply said force. The head (26) is moveable along substantially linear operating or return strokes, and is mounted on a rigid support (1, 2) through flexure means such a plate (32, 40). The flexure means constrains the head (26) so that latter moves only in the direction of said strokes.

## Description

### Field of the Invention

This invention relates apparatus for applying a controlled force to an article and to embossing apparatus.

### Background to the Invention

The demand for MNT (Micro Nano Technology) and MEMS (Micro Electro Mechanical Systems) micro devices is on the increase. In particular, microfluidic devices such as biochips (or microfluidic chips) are increasingly being adopted by the biochemical analysis industry. Such chips generally comprise a polymer substrate which carries a network of channels and various other microfluidic elements, for example peristaltic pumps, valves and chambers. Accordingly, there is a growing need to be able to fabricate such devices cheaply and quickly.

A number of fabrication methods are employed in the manufacture of these devices, including hot embossing, imprinting and injection moulding.

Although embossing and imprinting techniques do offer the potential for rapid and cheap mass production of microfluidic devices, they do require that the magnitude of an embossing/imprinting force applied through a suitable tool to an article is precisely controlled, and that the mechanism that applies the embossing/imprinting force to the article does not allow any lateral movement of the tool relative to the article. Generally, such mechanisms include surfaces which slide relative to each other, and this can create particles (undesirable in clean room environments), produce stick-slip and cause wear.

### Summary of the Invention

According to a first aspect of the invention, there is provided apparatus for applying a controlled amount of force to an article, the apparatus comprising a head for engaging such an article to apply said force, the head being moveable along substantially linear operating or return strokes; flexure means through which the head is mounted on a substantially rigid support means, and an actuator for moving the head, wherein the flexure means is so arranged as to constrain the head so that the latter moves only in the direction of said strokes.

It is known to provide flexure hinges in micro/nano positioning stages, although such hinges generally allow either hinging or two axis movement. In the present invention, the use of flexure means precisely to constrain the head is particularly suitable since flexures can exhibit a very high stiffness and load capacity, are less sensitive to shock and vibration (than a constraining mechanism which has sliding contacts), do not generate particles and theoretically can have an infinite life (if operated within their elastic limits).

Preferably, the apparatus is adapted for use in a process of creating surface features on an article, for example an embossing or imprinting process.

Preferably, the apparatus is embossing apparatus.

To that end, the apparatus may to advantage include an embossing or imprinting tool which is urged against the article by the action of the head.

In one example, the tool is carried by the head. Alternatively, the tool may be provided on a separate support and the article attached to the head, so that the latter drives the articles onto the tool.

Preferably, the actuator is operable to drive the head along its operating stroke.

The actuator preferably comprises a piezoactuator.

Such actuators provide very precise, controllable movement and force application with repeatability which is an order of magnitude better than that achievable with current stepper motor drives.

The flexure means is preferably resilient so as to exert on the head a biasing force in the direction of the return stroke.

This can provide a pre-loading force on the piezoactuator which can help to prevent damage to the latter.

The flexure means may to advantage comprise a plate.

In such a case, the direction of each stroke is preferably substantially perpendicular to the plate.

A disadvantage of known types of flexure is that they only provide a relatively limited range of allowable movement. However, the above mentioned feature permits a greater range of allowable movement, particularly if the head is situated centrally relative to the plate.

The movement the plate prevents will be in the plane of the plate. If the plate is non-compressible, the resistance offered to such movement will be considerable, so that the plate is also particularly suitable for providing the desired constraining effect.

Preferably, the plate is symmetrically arranged relative to the head. To that end, the plate may to advantage be circular and concentric with the head. Preferably, the head is also circular.

Preferably, the apparatus includes one or more conduits for enabling gas pressure on either side of the plate to be equalised. Preferably, the or each conduit is provided in the plate.

The conduits enable the apparatus to be used in conjunction with a vacuum chamber. Preferably, the plate is one of two such plates which are parallel to each other and are spaced from each other in the direction of the strokes.

This feature increases the biasing force exerted by the flexure means on the head, and also provide greatly increased resistance to any rocking movement of the head. Furthermore, since one plate can overlie the other, these effects are achieved without substantially increasing the lateral extent (i.e. dimensions lateral to the strokes) of the apparatus.

The piezoactuator may conveniently be connected to the head through a linkage for providing mechanical amplification of the actuator stroke.

This helps to compensate for the relatively limited stroke length provided by piezoactuators. In addition, the characteristics of the linkage may be chosen to provide any selected force/length characteristics from a range of possible characteristics for a given type of piezoactuator.

Preferably, the linkage comprises a rod attached to the head and a lever attaching the rod to the actuator.

In such a case, the magnitude of mechanical amplification will be related to the position of the pivot for the lever relative to the piezoactuator and the rod.

Preferably, the rigid support means comprises a frame on which the flexure means is mounted.

Because the piezoactuator is separate from the head, it can be replaced without interfering with the head and the flexure means.

According to a second aspect of the invention, there is provided embossing apparatus comprising a head for urging an embossing tool and an article together to cause the article to be embossed, a piezoactuator for moving the head relative to a support frame and flexure means mounting the head on the frame.

Preferably, the piezoactuator and rod are disposed substantially parallel and adjacent to each other, the piezoactuator having an operating stroke in the opposite direction to that of the head, and hence the rod.

This position of the rod and piezoactuator enable the apparatus to be of a relatively compact construction.

### Brief Description of the Drawings

The invention will now be described, by way of example only, with reference to the accompanying drawings in which:
Figure 1 is an isometric view of an embodiment embossing apparatus in accordance with the invention;
Figure 2 is a sectional side view of the apparatus;
Figure 3 is an isometric view of the apparatus from a different angle from Figure 1;
Figure 4 is an exploded isometric view of part of the apparatus, the view being taken from one side and slightly above;
Figure 5 is a corresponding view to Figure 4 but taken from one side and below;
Figure 6 is a sectional side view of the parts shown in Figures 4 and 5 when assembled;
Figure 6A is a more detailed view of part of the arrangement as shown in Figure 6;
Figures 7 and 8 are isometric and sectional side views respectively of the apparatus when attached to a vacuum chamber;
Figure 8A is a more detailed view of part of the arrangement as shown in Figure 8; and
Figures 9 and 9A are isometric views, from different angles, of parts of a second embodiment of the embossing apparatus, having a pair of parallel piezoactuators operating through a common linkage.

### Detailed Description

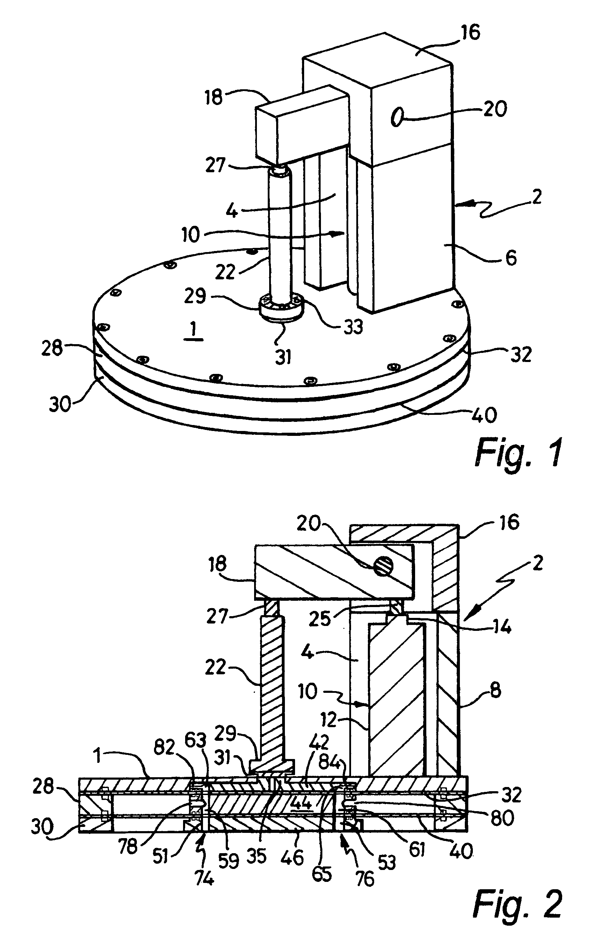

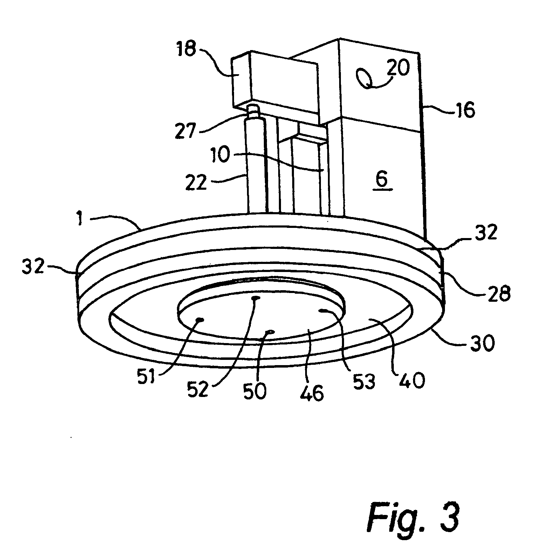

With reference to Figures 1 - 3, an embodiment of embossing apparatus in accordance with the invention has a frame comprising a circular base plate 1 and a vertical support post 2 attached to the plate 1 at a position offset from the centre of the latter. The post 2 is substantially U-shaped in horizontal cross-section so as to define two side portions 4 and 6 and a back portion 8. The post 2 thus also defines a vertical gap, and this accommodates a preloaded high-load piezoactuator 10 which is also vertically disposed and attached at its base to the base plate 1.

Piezoactuators of this type are known and this element has not therefore been described in detail (the cross-sectional view of the element in Figure 2 omitting all of the internal structures of the actuator for the sake of clarity). The piezoactuator 10 has a cylindrical body 12 from the top of which a rod 14 extends. The rod 14 is slideable relative to the body 12 and coupled to the piezoelectric materials (typically polycrystalline ceramics) that expand and contract when a voltage is applied. Thus increasing decreasing voltage applied to the piezoelectric materials within the body 12 causes the rod 14 to move up or down.

On top of the post 2 there is provided a bracket 16 in the form of a parallelepipidal block provided with a slot that is aligned with the gap defined by the post 2, and into which the top bracket 16, and which is pivotally mounted on that bracket by a pin 20. As can be seen from Figure 2, the line of action of the piezoactuator 10 is disposed behind the pin 20, i.e. at the inboard end of the lever 18. The outboard end of the lever 18 extends over the central axis of the plate 1 and acts on a vertical push rod 22 which is coaxial with the plate 1. The rod 22 terminates at its lower end in a flange 29 attached to a head assembly 26, underneath the plate 1, through an adapter plate 31.

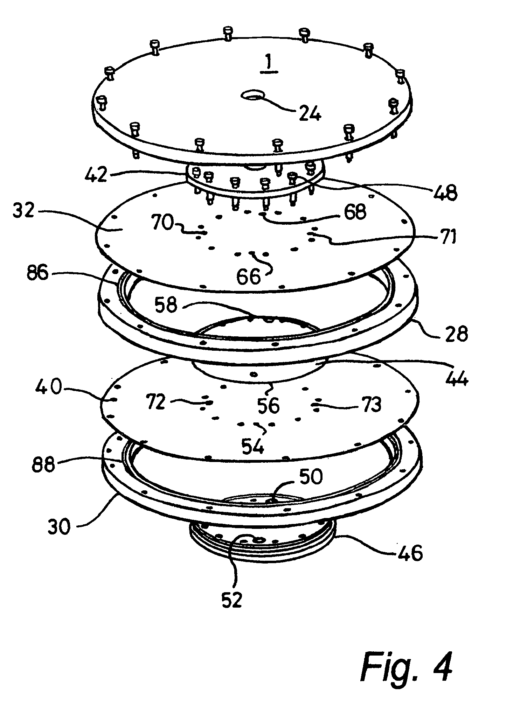

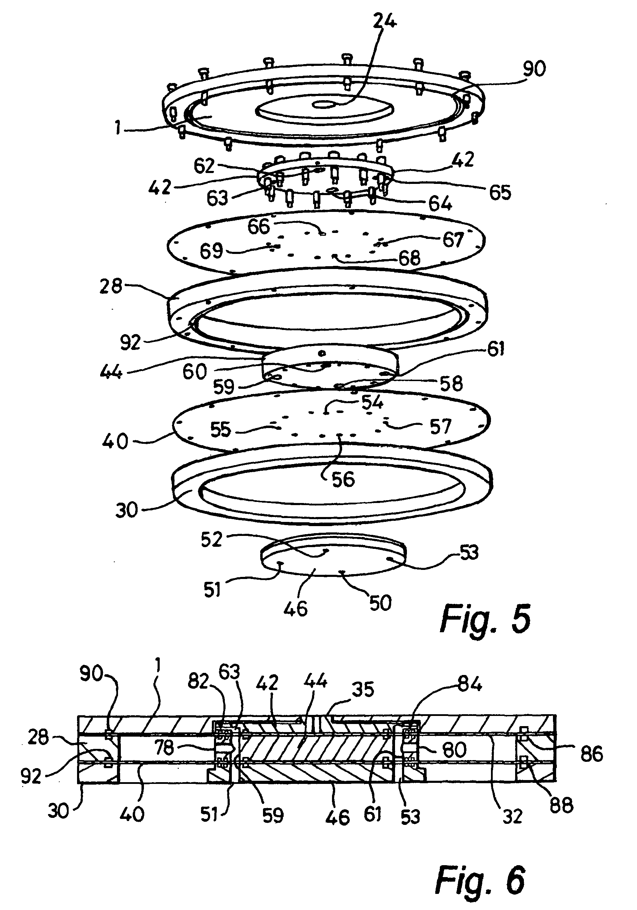

As can be seen from Figure 1, the flange 29 is attached to the adapter plate 31 by six screws (e.g. screw 33). The adapter plate 31 is, in turn, attached to a central cylindrical spigot 35 in the head assembly 26, the spigot extending through a central aperture 24 (Figures 4 and 5) in the base plate 1. In this example the adapter plate 31 is attached to the spit 35 by means of vertical screws (not shown).

The rod 14 is connected to the lever 18 via a flexible stainless steel connector 25 whilst the connection between the lever 18 and rod 22 is via another connector (referenced 27) of this type. The connectors enable the linear piezoelectric actuator motion to be converted into a tilt motion at the lever 18 and vice versa at the rod 22.

As can be seen from Figure 1, the flange 29 is attached to the adapter plate 31 by six screws (e.g. screw 33). The adapter plate 31 is, in turn, attached to a central, cylindrical spigot 35 in the head assembly 26, the spigot extending through a central aperture 24 (Figures 4 and 5) in the base plate 1. In this example the adapter plate 31 is attached to the spigot 35 by means of vertical screws (not shown).

The frame further comprises two rings 28 and 30 attached to the underside of the plate 1 and defining (with the plate) a circular recess in which the head assembly 26 is housed. All of the components of the frame and head assembly are stainless steel, BSEN10088-3:1995, 1.4301 (formerly grade 304), with manufacturing tolerances applied to ensure suitable alignment of components. The head assembly 26 is mounted on the frame through a pair of parallel circular flexure plates 32 and 40 which are also stainless steel (17-4PH heat treated to condition A), and have a thickness of approximately 0.8mm and a diameter of 350mm.

The desired dimensional characteristics of the plates are determined from such parameters as the required operational stroke and the mechanical properties of the plates (yield stress, for example).

The construction and interrelationship of the head assembly 26, the rings 28 and 30 and the flexure plates 32 and 40 can be more clearly seen in Figures 4 and 5.

The head assembly 26 comprises an upper disk 42 attached to middle and lower disks, referenced 44 and 46 respectively by 12 equi-angularly arranged stainless steel fixing bolts, which pass through corresponding holes in the three disks of the head assembly. One of those fixing bolts is denoted by the reference numeral 48 in Figure 4. Since the other fixing bolts are apparent and identical to the bolt 48, they have not been denoted by reference numerals.

Those fixing bolts also extend through corresponding holes in the flexure plates 32 and 40 so that the plate 32 is held firmly between disks 42 and 44, and the plate 40 between disks 44 and 46. The disk 46 has four equi-angularly arranged axial passages 50-53 (i.e. passages extending parallel to the axis of the rod 22) these are aligned with corresponding apertures 54-57 in the plate 40, similar channels 58-61 in the middle disk 44, channels 62-65 in the upper disk 42 and apertures 66-69 in the plate 32. Similarly, the plates 32 and 40 have further holes 70 - 73 which are in register with the remaining holes in the upper, middle and lower disks of the head assembly.

The head assembly therefore provides four passages which extend axially from the underside of the lower disk 46 to just beneath the top surface of the upper disk 42, said passages also extending through the plates 32 and 40.

In Figure 2 two of these passages are generally referenced 74 and 76. Each of the middle and upper disks of the head assembly also has four radial passages, each communicating with a respective axial passage. In Figure 2, two of the four radial passages in the middle disk 44 are shown at 78 and 80, whilst the corresponding passages in the upper disk 42 are shown at 82 and 84.

Thus, when the apparatus is attached to a vacuum chamber, the passages permit the pressures on either sides of the two flexure disks to equalise (as a result of gas being exhausted through the axial and radial passages).

The frame rings 28 and 30 have annular grooves 86 and 88 in their upper surfaces, each of which accommodates a respective O ring seal.

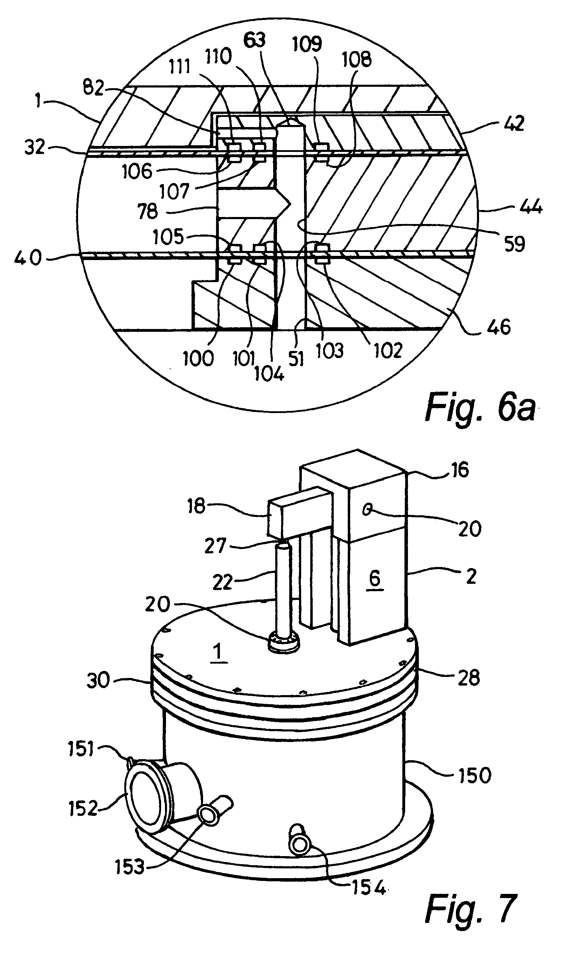

The base plate 1 and frame ring 28 also have respective annular grooves 90 and 92 in their lower surfaces, also for accommodating O-ring seals. Accordingly, flexure plate 32 is sealed within the underside of the base plate 1 and the top surface of the ring 28, whilst the plate 40 is sealed against the underside of the ring 28 and the top of the ring 30. The components of the head assembly 26 also have annular grooves for O ring seals (100-111 in Figure 6A).

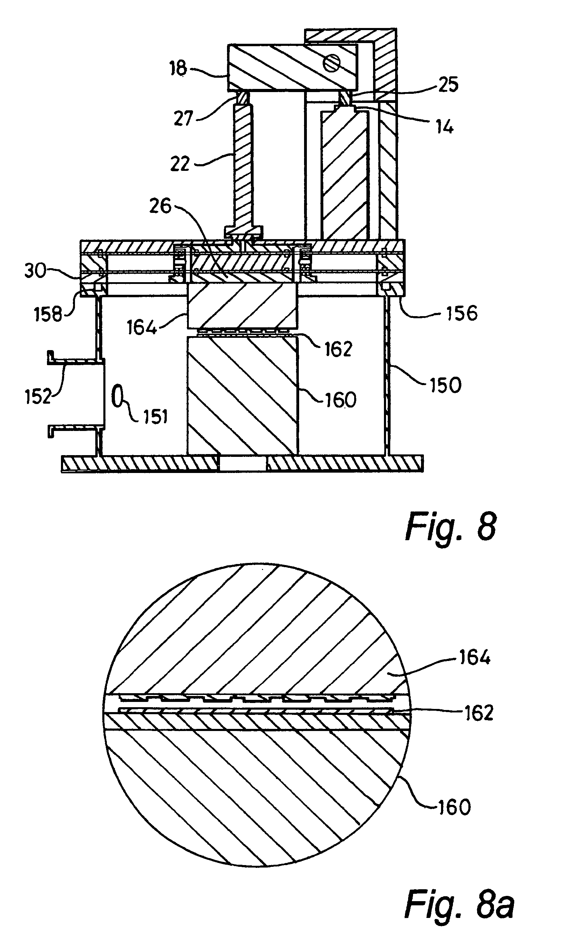

Consequently, when the apparatus is mounted on a vacuum chamber (referenced 100 in Figures 7 and 8) the vacuum in the chamber can be communicated in and maintained in the spaces between the flexure plates and the frame of the apparatus. In this arrangement, there is also, of course, a seal between the underside of the ring 30 and the top of the vacuum chamber 100, but this has been omitted for the sake of clarity.

The embossing tool is carried on the underside of the lower disk 46 of the head assembly. This head will be specific to the type of embossing operation to be carried out.

In use, a suitable voltage fed to the piezoactuator 10 will cause an extending force to exerted by the actuator on its rod 14. This force will create a moment on the lever 18 about the pivot 20 which, in turn, results in a downward force being exerted on the rod 22. The head assembly 26 is constrained by the flexure plates 32 and 40. However, those plates can flex to a limited degree in a direction normal to their faces, so as to allow a controlled downward movement of the head assembly 26. As the plates are deformed in this way, they will exert an upward biasing force on the head assembly 26. However, the plates 32 and 40 have a high tensile strength and will therefore strongly resist movement of the head assembly 26 in directions parallel to the planes of the plates. The plates 32 and 40 thus will substantially prevent horizontal movement of the head assembly 26. In addition since the plates are vertically spaced from each other, rocking movement of the head assembly 26 (about a horizontal axis) is also effectively prevented.

The permitted vertical movement of the head 26 in response to extension of the actuator 10 drives an embossing tool into a substrate to be embossed. The constraining effects of the flexure plates ensure that the movement of the embossing tool is normal to the surface of the substrate so that any errors or inaccuracies caused by lateral movements of the tool are avoided.

The actuator 10 can be removed and replaced without affecting the mounting of the head assembly 26 on the plates 32 and 40. In addition the mechanical reduction or amplification of the stroke of the actuator 10 as transmitted to the rod 22 can be changed by selecting a post 2 having a different geometry, more particularly a post in which the pivot point of the lever 18 is in a different position.

It has been found that the apparatus in accordance with the invention is able to exert typical embossing forces (several kN) on a substrate whilst constraining the head assembly 26 to move only in a vertical downwards direction (i.e. along the axis of rod 22), constituting the operating stroke of the device. When the voltage applied to piezoactuator 10 is reduced the rod 14 retracts, causing the head assembly 26 to move vertically upwards (in the reverse stroke). The resilience of the plates 32 and 40 assists in this upward movement, but the additional retracting force exerted by the piezoactuator 10 may be needed to separate the embossing tool from the substrate.

The flexibility of the design of the apparatus enables a range of processes to be conducted by the same mechanism. Accurate linear motion is provided with sub-micron position capability should embossing with precise depth and feature control be required. Emboss depths can be accommodated up to several hundred microns, to satisfy most precision embossing requirements. Alternatively, embossing by force control is also possible with applied forces available up to several kN.

To provide additional flexibility within the MEMS market, the apparatus is designed to interface with typical vacuum chambers, such as those used in wafer bonding processes. This is illustrated in Figures 7, 8 and 8A.

The vacuum chamber comprises a cylindrical housing 150 having radial inlet/outlet ports 151-154 and upper flange 156 to which the lower ring 30 of the frame of the apparatus is attached by, for example, screws extending from the underside of the flange 156 into correspondingly threaded blind bores in the underside of the ring 30. Reference numeral 158 denotes an annular groove in the in the top of the flange 156 for accommodating an O ring seal so that the apparatus is sealed against the vacuum chamber.

As can be seen from Figure 8, the vacuum chamber includes a table 160 for carrying a substrate 162 to be embossed by an embossing tool 164 attached to the head assembly 26.

The ability to perform wafer bonding is not impaired by the addition of the apparatus, meaning that multiple processes can be conducted by the same assembly.

For example, the embossing apparatus (with the embossing tool removed) may be used to hold together the faces of wafers (typically of silicone and glass) with forces which are much lower than those used in embossing processes, but which are suitable for wafer bonding processes. Thus the apparatus could be used, for example, to create an embossed susbstrate and/or to bond that substrate to another wafer to create, for example, a sealed biochip.

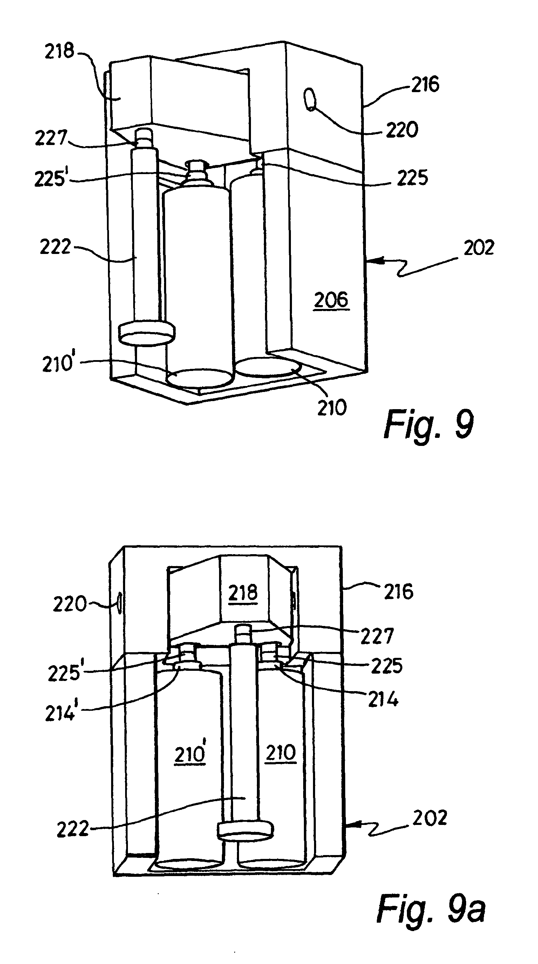

Figures 9 and 9A show components of a modified version of the apparatus which are similar to the corresponding components on the first described embodiment, and are therefore denoted by the reference numerals used in relation to-the first embodiment, raised by 200. The components include a post 202 which is wider than the post 2, so as to be able to accommodate a pair of parallel piezoactuators 210 and 210', which are respectively connected to a common overhead lever 218 by means of connectors 227 and 227'. It can be seen from the figures that the lever 218 is, in plan, in the shape of a truncated triangle so as to be wide enough to be connected to both piezoactuators, whilst acting on the rod 222 which is in a central position relative to the piezoactuators.

## Claims

1. Apparatus for applying a controlled amount of force to an article, the apparatus comprising a head for engaging such an article to apply said force, the head being moveable along substantially linear operating or return strokes; flexure means through which the head is mounted on a substantially rigid support means, and an actuator for moving the head, wherein the flexure means is so arranged as to constrain the head so that the latter moves only in the direction of said strokes.

2. Apparatus according to claim 1, in which the apparatus is adapted for use in a process of creating surface features on an article, for example an embossing or imprinting process.

3. Apparatus according to claim 1 or claim 2, in which the apparatus is embossing apparatus.

4. Apparatus according to claim 3, in which the apparatus includes an embossing or imprinting tool which is urged against the article by the action of the head.

5. Apparatus according to any of the preceding claims, in which the actuator is operable to drive the head along its operating stroke.

6. Apparatus according to any of the preceding claims, in which the actuator comprises a piezoactuator.

7. Apparatus according to any of the preceding claims, in which the flexure means is resilient so as to exert on the head a biasing force in the direction of the return stroke.

8. Apparatus according to any of the preceding claims, in which the flexure means comprises a plate.

9. Apparatus according to claim 8, in which, the direction of each stroke is substantially perpendicular to the plate.

10. Apparatus according to claim 8 or claim 9, in which the plate is symmetrically arranged relative to the head.

11. Apparatus according to claim 10, in which the plate is circular and concentric with the head.

12. Apparatus according to any of claims 8 to 11, in which the apparatus includes one or more conduits for enabling gas pressure on either side of the plate to be equalised.

13. Apparatus according to claim 12, in which the or each conduit is provided in the plate.

14. Apparatus according to any of claims 8 to 13 in which the plate is one of two such plates which are parallel to each other and are spaced from each other in the direction of the strokes.

15. Apparatus according to any of the preceding claims, in which the piezoactuator is connected to the head through a linkage for providing mechanical amplification of the actuator stroke.

16. Apparatus according to claim 15, in which the linkage comprises a rod attached to the head and a lever attaching the rod to the actuator.

17. Apparatus according to any of the preceding claims, which the rigid support means comprises a frame on which the flexure means is mounted.

18. Embossing apparatus comprising a head for urging an embossing tool and an article together to cause the article to be embossed, a piezoactuator for moving the head relative to a support frame and flexure means mounting the head on the frame.

19. Embossing apparatus according to claim 18, in which the piezoactuator and rod are disposed substantially parallel and adjacent to each other, the piezoactuator having an operating stroke in the opposite direction to that of the head, and hence the rod.
